# EUROPÄISCHE PATENTSCHRIFT

(11) **EP 3 289 840 B1**
(45) Veröffentlichungstag und Bekanntmachung des Hinweises auf die Patenterteilung: **16.12.2020**
(21) Anmeldenummer: 16707727.0
(22) Anmeldetag: 02.03.2016
(51) Int. Cl.: H05K 5/00, H05K 7/20

(54) **ELEKTRONIKMODUL FÜR EIN GETRIEBESTEUERGERÄT**
ELECTRONICS MODULE FOR A TRANSMISSION CONTROL UNIT
MODULE ÉLECTRONIQUE POUR APPAREIL DE COMMANDE DE TRANSMISSION

(30) Priorität: 29.04.2015 DE 102015207873
(43) Veröffentlichungstag der Anmeldung: 07.03.2018
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2016/054362
(87) Internationale Veröffentlichungsnummer: WO 2016/173746

(56) Entgegenhaltungen:
- EP-A2- 1 239 710
- DE-A1-102008 043 169

## Beschreibung

### Gebiet der Erfindung

Die Erfindung betrifft allgemein Elektronikmodule. Insbesondere betrifft die Erfindung Elektronikmodule mit einem Sensorelement für ein Getriebesteuergerät eines Kraftfahrzeugs.

### Stand der Technik

Zur Steuerung von Getrieben, insbesondere Automatikgetrieben, in einem Kraftfahrzeug werden Elektronikmodule verwendet, die in der Regel eine Getriebesteuereinheit mit einer elektronischen Schaltung ("transmission control unit", TCU), mindestens eine Steckverbindung zum Anschluss an einen Fahrzeugkabelbaum, elektrische Schnittstellen zum Ansteuern von Aktuatoren und wenigstens ein Sensorelement aufweisen.

Die Sensorelemente können insbesondere zur Bestimmung einer Drehzahl und/oder zur Bestimmung von Wegen bzw. Positionen in dem Getriebe ausgeführt sein. Beispielsweise können derartige Sensorelemente als Hallsensoren ausgeführt sein, etwa in Form einer integrierten Schaltung (bzw. eines "Integrated Circuits", IC) oder in Form einer anwendungsspezifischen integrierten Schaltung (bzw. "Application-Specific Integrated Circuit", ASIC).

In der Regel werden Anschlussdrähte bzw. elektrische Leitungen des Sensorelements an ein Zwischenstanzgitter geschweißt und diese Baugruppe kann an einem Kunststoffdom bzw. Domkörper montiert sowie anschließend mit einer Vergussmasse, etwa einer epoxidharbasierten, einer silikonbasierten und/oder einer polurethanbasierten Vergussmasse, zu einem sogenannten Sensordom ausgeformt werden. Alternativ kann diese Baugruppe im Bereich des Sensorelements mit einem Duroplastmaterial ummoldet bzw. umspritzt werden, wobei in einem weiteren Prozessschritt beispielsweise mit Thermoplastmaterial der eigentliche Sensordom ausgeformt werden kann.

Die Sensordome können dann auf dem Elektronikmodul montiert und elektrisch mit Komponenten des Elektronikmoduls kontaktiert werden, insbesondere mit der elektronischen Schaltung der Getriebesteuereinheit.

Die EP 1 239 710 A2 offenbart eine elektronische Baugruppe, bei welcher ein Sensorelement durch Schweißen mit einer Leiterfolie elektrisch leitend verbunden ist. Eine weitere elektronische Baugruppe ist aus DE 10 2008 043169 A1 vorbekannt.

### Offenbarung der Erfindung

### Vorteile der Erfindung

Die folgende technische Aufgabe der Erfindung wird durch Anspruch 1 gelöst. Weitere Ausführungsbeispiele sind in den abhängigen Ansprüchen aufgeführt. Ausführungsformen der vorliegenden Erfindung können in vorteilhafter Weise ermöglichen, ein robustes, zuverlässiges und kostengünstig produzierbares Elektronikmodul für ein Getriebesteuergerät eines Kraftfahrzeuges bereitzustellen.

Gemäß einem Aspekt der Erfindung wird ein Elektronikmodul für ein Getriebesteuergerät eines Kraftfahrzeugs vorgeschlagen, welches eine Getriebesteuereinheit mit einer elektronischen Schaltung, wenigstens ein Trägerelement und wenigstens einen Sensordom aufweist. Der Sensordom weist einen länglich ausgebildeten Domkörper auf, welcher mit einem ersten Ende auf dem Trägerelement angeordnet ist und welcher von dem Leiterplattenelement abragt, wobei der Sensordom an einem dem ersten Ende gegenüberliegenden zweiten Ende ein elektronisches Sensorelement aufweist, welches wenigstens zwei elektrische Leitungen aufweist, welche jeweils an einer Kontaktstelle mit einer zwischen einer Deckschicht und einer Basisschicht angeordneten Leiterbahn einer Leiterfolie elektrisch leitfähig verbunden sind. Die Leiterbahnen der Leiterfolie sind jeweils mit der elektronischen Schaltung der Getriebesteuereinheit elektrisch leitfähig verbunden, und das Sensorelement ist mit einer Vergussmasse umspritzt, welche das Sensorelement zumindest an einem Außenumfang des Sensorelements vollständig umschließt. Das erfindungsgemäße Elektronikmodul zeichnet sich insbesondere dadurch aus, dass die wenigstens zwei elektrischen Leitungen des Sensorelements, die Kontaktstellen und ein Bereich der Leiterfolie von der Vergussmasse derart umspritzt sind, dass die elektrischen Leitungen und die Kontaktstellen durch die Vergussmasse voneinander getrennt sind. Die Vergussmasse kann zusammen mit Sensorelement ein Deckelement des Sensordoms bilden. Die Vergussmasse kann dabei eine Art Kapselung für das Sensorelement, die Kontaktstellen und die Leitungen bereitstellen, wobei die Kapselung dicht gegenüber das Elektronikmodul umspülendes Getriebefluid sein kann.

Das Trägerelement kann ein rein mechanisches Trägerelement bezeichnen, beispielsweise eine mechanische Trägerstruktur, auf welcher der Sensordom befestigt sein kann. Auch kann das Trägerelement wenigstens ein Stanzgitter aufweisen und/oder bezeichnen. Ferner kann das Trägerelement wenigstens ein Leiterplattenelement und/oder eine Leiterplatte aufweisen, beispielsweise ein HDI- ("High-Density Interconnect") und/oder ein PCB-Leiterplattenelement ("Printed Circuit Board").

Fertigungstechnisch kann das Sensorelement mit den elektrischen Leitungen, welche bereits an den Kontaktstellen mit den Leiterbahnen der Leiterfolie kontaktiert sein können, beispielsweise auf dem zweiten Ende des z.B. aus Duroplast und/oder Thermoplast vorgefertigten Domkörpers positioniert werden und anschließend kann das Sensorelement, die Leitungen mit Kontaktstellen sowie der Bereich der Leiterfolie mit der Vergussmasse umspritzt werden. Dabei können die Leitungen sowie die Kontaktstellen insbesondere vollständig mit Vergussmasse umspritzt sein, so dass die Leitungen und die Kontaktstellen vollständig in der Vergussmasse eingebettet bzw. in dieser vergossen sein können. Die Kontaktstellen und/oder die Leitungen können dabei dicht von der Vergussmasse umschlossen sein. Die Leiterfolie kann mit einer Seite auf dem Domkörper aufliegen und auf einer gegenüberliegenden Seite können sich die Kontaktstellen befinden. Entsprechend kann der mit Vergussmasse umspritzte Bereich der Leiterfolie beispielsweise wenigstens eine Seite eines Endes der Leiterfolie bezeichnen. Durch die erfindungsgemäße Umspritzung der Leitungen des Sensorelements und der Kontaktstellen können in vorteilhafter Weise Kurzschlüsse und/oder Nebenschlüsse zwischen den Leitungen vermieden werden, welche etwa durch elektrisch leitfähige Späne, leitende Ablagerungen wie z.B. Kupfersulfide und/oder leitende Medien hervorgerufen werden können, die in einem das Elektronikmodul umspülenden Getriebefluid vorhanden sein können. Derart kann die Umspritzung mit Vergussmasse insbesondere einen Spanschutz für den Sensordom und/oder das Elektronikmodul bereitstellen, da beispielsweise Getriebefluid nicht bis zu den Kontaktstellen und/oder den Leitungen des Sensorelements eindringen kann. Insgesamt kann so eine Robustheit des Sensordoms und/oder des Elektronikmoduls gesteigert sein.

Auch kann durch die direkte Kontaktierung der Leitungen des Sensorelements mit den Leiterbahnen der Leiterfolie ein Zwischenstanzgitter entfallen, wodurch Bauteile und Herstellungskosten für das Elektronikmodul reduziert werden können.

Das Sensorelement kann beispielsweise ein SMD-Baustein ("Surface Mounted Device"), ein ASIC und/oder ein IC sein. Das Sensorelement kann etwa eine mit Duroplast oder einem anderen geeigneten Material umspritzte Schaltung aufweisen, wobei die Leitungen des Sensorelements nicht zwingend dicht in das Material des Gehäuses eingebettet sind. Durch das Umspritzen des Sensorelements mit Vergussmasse können solche Bereiche zuverlässig und umfassend abgedichtet sein. Auch kann durch das Umspritzen mit Vergussmasse ein Verzinnen der Leitungen entfallen, was ferner eine Wisker-Neigung eliminieren und den Einsatz teurer Werkstoffe wie Zinn reduzieren kann. Die Vergussmasse kann beispielsweise ideal dicht und fest an den Leitungen des Sensorelements, welche aus Kupfer gefertigt sein können, sowie an dem Gehäuse des Sensorelements haften, insbesondere wenn dieses plasmabereinigt und/oder aktiviert ist. Dadurch kann ein robuster und zuverlässig abgedichteter Sensordom bereitgestellt sein.

Das Sensorelement kann auch zusammen mit der Leiterfolie in Standardprozessen vorkonfektioniert sein, und diese Baugruppe kann gegebenenfalls automatisiert während der Fertigung des Elektronikmoduls auf dem Domkörper positioniert und mit Vergussmasse vergossen werden. Dadurch können Herstellungskosten für das Elektronikmodul weiter reduziert werden. Auch können so modulspezifische Varianten des Sensorelements und/oder des Sensordomes vorgefertigt und/oder ausgebildet werden, was die Herstellung des Elektronikmoduls weiter vereinfachen kann.

Gemäß einer Ausführungsform der Erfindung weist die Leiterfolie eine Sensorausnehmung auf und das Sensorelement weist einen Sensorkörper auf, welcher in der Sensorausnehmung der Leiterfolie angeordnet ist, so dass ein Teilbereich der Leiterfolie den Sensorkörper an einem Außenumfang umläuft. Die Sensorausnehmung kann dabei mit der Vergussmasse zumindest teilweise ausgespritzt sein. Dies kann eine Positionierung des Sensorelements auf dem Domkörper vereinfachen und/oder verbessern, da beispielsweise wenigstens ein Rand der Leiterfolie zum Ausrichten und/oder Positionieren des Sensorelements auf dem Domkörper verwendet werden kann, etwa durch bündiges Ausrichten des wenigstens einen Randes der Leiterfolie mit einem Rand bzw. einer Außenkante des Domkörpers.

Gemäß einer Ausführungsform der Erfindung schließt eine an dem Teilbereich der Leiterfolie angeordnete Außenkante und/oder ein Rand der Leiterfolie zur Positionierung des Sensorelements auf dem Domkörper bündig mit einer Außenkante des Domkörpers ab. Die Außenkante des Domkörpers kann beispielsweise eine Außenkante einer Auflagefläche des Domkörpers bezeichnen, auf welcher das Sensorelement und der Teilbereich der Leiterfolie zumindest teilweise aufliegen können. Auch können mehrere Ränder bzw. Außenkanten der Leiterfolie bündig mit jeweils einer Außenkante des Domkörpers abschließen, so dass das Sensorelement in zwei orthogonalen Raumrichtungen auf der Auflagefläche des Domkörpers positioniert sein kann. Der den Sensorkörper umlaufende Teilbereich der Leiterfolie kann zumindest teilweise in die Vergussmasse eingebettet bzw. eingespritzt sein.

Gemäß einer Ausführungsform der Erfindung bildet die Sensorausnehmung zusammen mit einer zwischen den Kontaktstellen angeordneten Ausnehmung der Leiterfolie eine durchgehende Ausnehmung der Leiterfolie, welche zumindest teilweise mit Vergussmasse ausgespritzt ist. Die Sensorausnehmung und/oder die Ausnehmung kann dabei etwa ein in die Leiterfolie eingebrachte Ausstanzung sein. Die Ausnehmung zwischen den Kontaktstellen kann zum einen gewährleisten, dass die Leiterfolie sicher in der Vergussmasse gehalten ist und zum anderen kann durch die mit Vergussmasse ausgespritzte Ausnehmung eine Barriere gegen Späne und/oder leitende Ablagerungen zwischen den Kontaktstellen bereitgestellt sein. Insgesamt kann so eine Robustheit des Sensordoms und/oder des Elektronikmoduls gegenüber durch Späne und/oder Ablagerungen induzierten Kurzschlüssen und/oder gegenüber mechanischen Belastungen gesteigert sein.

Gemäß einer Ausführungsform der Erfindung weist die Leiterfolie zwischen den Kontaktstellen der elektrischen Leitungen mit den Leiterbahnen der Leiterfolie eine Ausnehmung auf, wobei die Ausnehmung zwischen den Kontaktstellen zumindest teilweise, vorzugsweise vollständig, mit der Vergussmasse ausgespritzt und/oder gefüllt ist. Derart kann die Leiterfolie zuverlässig in der Vergussmasse verankert sein, auch wenn etwa die Vergussmasse selbst nicht an der Leiterfolie bzw. einer Oberfläche der Leiterfolie haftet, und ein umfassender Spanschutz kann durch die zwischen den Kontaktstellen und in der Ausnehmung angeordnete Vergussmasse bereitgestellt sein.

Gemäß einer Ausführungsform der Erfindung ist die Vergussmasse formschlüssig an wenigstens einem durch den Domkörper ausgebildeten Hinterschnitt an dem zweiten Ende des Domkörpers gehalten. Die Vergussmasse kann sich etwa an dem Hinterschnitt des Domkörpers verkrallen und/oder den Hinterschnitt zumindest teilweise umgreifen, so dass ein robuster Sensordom bereitgestellt sein kann. Je nach Material der Vergussmasse und des Domkörpers kann die Vergussmasse auch eine stoffschlüssige Verbindung mit dem Domkörper eingehen bzw. kann die Vergussmasse stoffschlüssig an dem Domkörper befestigt sein.

Gemäß einer Ausführungsform der Erfindung enthält die Vergussmasse ein Material aus der Gruppe bestehend aus duroplastischem Material, thermoplastischem Material, epoxidharzbasiertem Material, silikonbasiertem Material, Polyurethan und Acrylklebstoff. Das Material der Vergussmasse kann beispielsweise je nach Medium gegen das das Sensorelement geschützt werden soll gewählt werden. Insbesondere Acrylklebstoff kann aufgrund dessen Haftung an einer Oberfläche der Leiterfolie vorteilhaft sein. Die Vergussmasse kann insbesondere thermisch- und/oder lichthärtend sein und etwa mit Hilfe eines Wärmestrahlers und/oder einer UV-Lichtquelle ausgehärtet werden, etwa bei tixotropem Verguss des Sensorelements. Gemäß einer Ausführungsform der Erfindung, schließt eine in Längserstreckungsrichtung des Sensordoms bzw. des Domkörpers gerichtete Außenfläche des Sensorelements bündig mit einer Außenfläche der Vergussmasse ab. Mit anderen Worten kann die Außenfläche des Sensorelements eine Außenfläche des Sensordoms bilden. Dies kann eine Verbesserung einer Funktion des Sensorelements bewirken, da beispielsweise ein Spalt zwischen der Außenfläche und einem von dem Sensorelement zu sensierendem Element eines Getriebes vergrößert werden kann. Auch kann dadurch Material der Vergussmasse eingespart werden und ein Gewicht des Sensordoms kann reduziert werden.

Gemäß einer Ausführungsform der Erfindung ist eine in Längserstreckungsrichtung des Sensordoms bzw. des Domkörpers gerichtete Außenfläche des Sensorelements mit einer Schicht aus Vergussmasse bedeckt, welche eine Schichtdicke von maximal 2 mm, vorzugsweise maximal 1 mm, aufweist. Dies kann einen Schutz des Sensorelements durch die Vergussmasse weiter verbessern.

Gemäß einer Ausführungsform der Erfindung weist der Sensordom eine Abschlusskappe auf, welche die Außenfläche des Sensorelements zumindest teilweise überdeckt. Die Abschlusskappe kann beispielsweise ein Formteil aus Duroplast, Polyamid, Polyamidimid und/oder einem anderen Kunststoff sein. Die Abschlusskappe kann eine Wandstärke maximal 1 mm, beispielsweise von wenigen Zehntelmillimetern, vorzugsweise zwei Zehntelmillimetern, aufweisen.

Gemäß einer Ausführungsform der Erfindung weist der Domkörper an dem zweiten Ende wenigstens einen Führungssteg zur Positionierung des Sensorelements auf dem Domkörper auf. Der Führungssteg kann z.B. parallel zu einer Außenkante und/oder einer Flanke des Domkörpers verlaufen. Das Sensorelement kann zum Positionieren beispielsweise entlang des Führungsstegs an eine vorbestimmte Position auf dem Domkörper verschoben werden. Auch können z.B. zwei Paare mit je zwei Führungsstegen vorgesehen sein, wobei die Führungsstege eines Paares parallel und die Führungsstege unterschiedlicher Paare im Wesentlichen orthogonal zueinander verlaufen können, so dass das Sensorelement in zwei zueinander orthogonalen Raumrichtungen auf dem Domkörper positioniert werden kann.

Ein weiterer Aspekt der Erfindung kann ein Verfahren zum Herstellen eines Elektronikmoduls betreffen, so wie obenstehend und untenstehend beschrieben. Ferner kann ein weiterer Aspekt der Erfindung ein Getriebesteuergerät mit einem Elektronikmodul, so wie obenstehend und untenstehend beschrieben, betreffen.

Es wird darauf hingewiesen, dass einige der möglichen Merkmale und Vorteile des Elektronikmoduls hierin mit Bezug auf unterschiedliche Ausführungsformen beschrieben sind. Ein Fachmann erkennt, dass die Merkmale in geeigneter Weise kombiniert, angepasst oder ausgetauscht werden können, um zu weiteren Ausführungsformen der Erfindung zu gelangen.

### Kurze Beschreibung der Zeichnungen

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Fig. 1 zeigt ein Elektronikmodul gemäß einer Ausführungsform der Erfindung.
Fig. 2A zeigt einen Längsschnitt durch einen Sensordom für ein Elektronikmodul gemäß einer Ausführungsform der Erfindung.
Fig. 2B zeigt eine Draufsicht auf den Sensordom der Fig. 2A.
Fig. 3A zeigt einen Längsschnitt durch einen Sensordom für ein Elektronikmodul gemäß einer Ausführungsform der Erfindung.
Fig. 3B zeigt eine Draufsicht auf den Sensordom der Fig. 3A.
Fig. 4A zeigt einen Längsschnitt durch einen Sensordom für ein Elektronikmodul gemäß einer Ausführungsform der Erfindung.
Fig. 4B und 4C zeigen jeweils eine Draufsicht auf den Sensordom der Fig. 4A gemäß Ausführungsformen der Erfindung.
Fig. 5 zeigt eine Draufsicht auf einen Sensordom für ein Elektronikmodul gemäß einer Ausführungsform der Erfindung.
Fig. 6, 7 und 8 zeigen jeweils einen Längsschnitt durch einen Sensordom für ein Elektronikmodul gemäß Ausführungsformen der Erfindung

Die Figuren sind lediglich schematisch und nicht maßstabsgetreu. Gleiche Bezugszeichen bezeichnen in den Figuren gleiche oder gleichwirkende Merkmale.

### Ausführungsformen der Erfindung

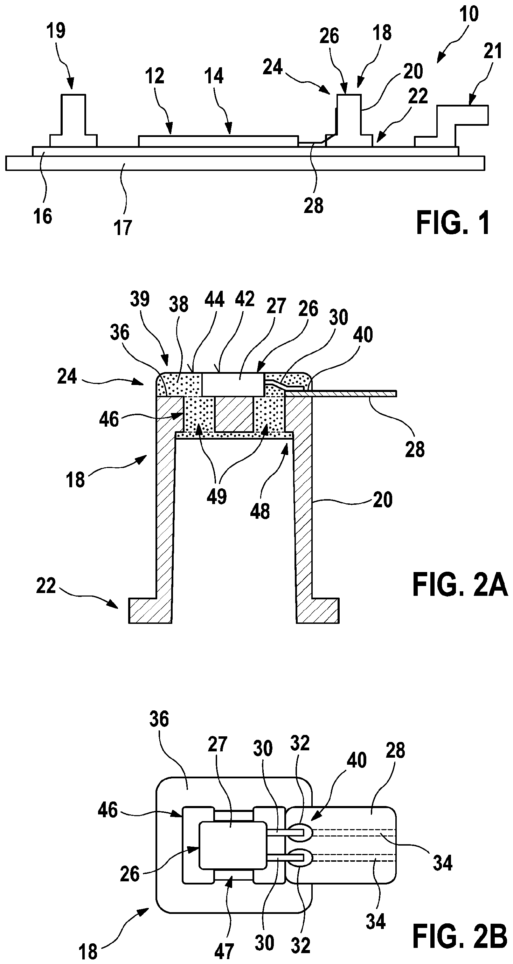

Fig. 1 zeigt ein Elektronikmodul 10 für ein Getriebesteuergerät eines Kraftfahrzeugs gemäß einer Ausführungsform der Erfindung.

Das Elektronikmodul 10 weist eine Getriebesteuereinheit ("Transmission Control Unit", TCU) 12 mit einer elektronischen Schaltung 14 auf, welche auf einem Leiterplattenelement 16 angeordnet und befestigt ist. Das Leiterplattenelement 16 kann etwa ein HDI ("High-Density Interconnect") und/oder ein PCB ("Printed Circuit Board") Leiterplattenelement sein. Das Elektronikmodul 10 kann auch eine Mehrzahl von Leiterplattenelementen 16 aufweisen, beispielsweise ein Leiterplattenelement 16, auf welchem die Getriebesteuereinheit 12 angeordnet ist und weiteres Leiterplattenelement, auf welchem weitere Komponenten des Elektronikmoduls 10 angeordnet sind und welches das Leiterplattenelement 16 z.B. entlang eines Umfangs ringförmig umschließt.

Das Leiterplattenelement 16 ist auf einer Trägerplatte 17 angeordnet und/oder befestigt. Die Trägerplatte 17 kann insbesondere zum Abführen von Wärme aus Metall, z.B. Aluminium, und/oder einem Keramikmaterial gefertigt sein. Die Trägerplatte 17 kann z.B. auf einer Getriebesteuerplatte befestigt sein oder die Getriebesteuerplatte kann gleichzeitig die Funktion der Trägerplatte haben.

Weiter weist das Elektronikmodul 10 einen Sensordom 18 auf, welcher einen länglichen Domkörper 20 aufweist und mit einem ersten Ende 22 auf dem Leiterplattenelement 16 angeordnet und/oder befestigt ist. Der Sensordom 18 ragt dabei im Wesentlichen parallel zu einem Flächennormalenvektor des Leiterplattenelements 16 von dem Leiterplattenelement 16 ab. Der Sensordom 18 weist an einem dem ersten Ende 22 gegenüberliegenden zweiten Ende 24 ein elektronisches Sensorelement 26 (siehe Fig. 2) auf, beispielsweise einen ASIC, einen IC, einen SMD-Baustein und/oder ein anderes Sensorelement.

Das Sensorelement 26 ist elektrisch leitfähig mit einer Leiterfolie 28 verbunden, wie im Detail in nachfolgenden Figuren beschrieben. Die Leiterfolie 28 ist ferner mit der Getriebesteuereinheit 12 und/oder der elektronischen Schaltung 14 elektrisch leitfähig verbunden.

Das Elektronikmodul 10 weist ferner einen weiteren Sensordom 19 auf, welcher entweder ähnlich dem Sensordom 18 ausgestaltet und mit einer Leiterfolie elektrisch kontaktiert sein kann oder anders elektrisch kontaktiert sein kann.

Ferner weist das Elektronikmodul 10 einen Steckverbinder 21 auf, welcher beispielsweise mit elektrischen Leitungen eines Kraftfahrzeugs, z.B. einem Kabelbaum, verbunden werden kann.

Fig. 2A zeigt einen Längsschnitt durch einen Sensordom 18 für ein Elektronikmodul 10 gemäß einer Ausführungsform der Erfindung. Fig. 2B zeigt eine Draufsicht auf den Sensordom 18 der Fig. 2A.

Das Sensorelement 26 weist einen Sensorkörper 27 und wenigstens zwei elektrische Leitungen 30 auf, welche jeweils an einer Kontaktstelle 32 mit einer Leiterbahn 34 der Leiterfolie 28 elektrisch leitfähig verbunden ist. Die Leitungen 32 und die Leiterbahnen 34 können beispielsweise verlötet, verschweißt und/oder mittels Leitkleber verklebt sein. Die Leiterbahnen 34 der Leiterfolie 28 sind dabei zwischen einer Basisschicht und einer Deckschicht der Leiterfolie 28 aufgenommen und/oder angeordnet, wobei im Bereich der Kontaktstellen 32 die Basisschicht oder die Deckschicht zum elektrischen Kontaktieren der Leiterbahnen 34 mit den Leitungen 32 abgetragen sein kann. Weiter können die Leiterbahnen 34 mit der Getriebesteuereinheit 12 und/oder der elektronischen Schaltung 14 elektrisch leitfähig verbunden sein, wobei die Leiterfolie 28 etwa seitlich von dem Domkörper 20 abragen kann oder an einer Flanke des Domkörpers 20 anliegen kann.

Das Sensorelement 26 und/oder der Sensorkörper 27 liegt auf einer an dem zweiten Ende 24 des Domkörpers 20 angeordneten Auflagefläche 36 auf und ist mit einer Vergussmasse 38 umspritzt, welche das Sensorelement 26 und/oder den Sensorkörper 27 an einem Außenumfang umschließt. Die Vergussmasse 38 kann duroplastisches Material, thermoplastisches Material, epoxidharzbasiertes Material, silikonbasiertes Material, Polyurethan und/oder Acrylklebstoff enthalten. Die Vergussmasse 38 umschließt dabei die wenigstens zwei elektrischen Leitungen 30 des Sensorelements 26 und die Kontaktstellen 32 vollständig, so dass die Leitungen 30 und die Kontaktstellen gegen das Elektronikmodul 10 und/oder den Sensordom 18 umspülendes Getriebefluid abgedichtet sind. Derart können Kurz- und/oder Nebenschlüsse zwischen den Kontaktstellen 32 und/oder den Leitungen 30, welche durch Späne, Ablagerungen und/oder leitende Komponenten des Getriebefluids hervorgerufen werden können, vermieden werden. Ferner ist ein Bereich 40 der Leiterfolie 28 mit Vergussmasse 38 umspritzt, wobei der Bereich 40 etwa eine mit der Vergussmasse 38 in Kontakt stehende Seite eines Endes der Leiterfolie 28 sein kann. Eine dieser Seite gegenüberliegende Seite des Endes der Leiterfolie 28 kann auf der Auflagefläche 36 des Domkörpers 20 aufliegen. Auch können beide Seiten des Endes der Leiterfolie 38 mit Vergussmasse 38 umspritzt sein, d.h. es kann auch zwischen der Auflagefläche 36 und der Leiterfolie 28 Vergussmasse 38 angeordnet sein.

Wie in Fig. 2A deutlich erkennbar, kann die Vergussmasse 38 zusammen mit dem darin zumindest teilweise eingebetteten Sensorelement 26 ein Deckelement 39 des Sensordoms 18 bilden, welches an dem zweiten Ende 24 des Domkörpers 20 angeordnet ist. Der Übersichtlichkeit halber ist in Fig. 2B die Vergussmasse 38 nicht gezeigt.

Vorzugsweise schließt eine Außenfläche 42 des Sensorelements 26 und/oder des Sensorkörpers 27, welche etwa eine Sensoroberfläche sein kann, bündig mit einer Außenfläche 44 der Vergussmasse 38 ab, so dass eine Sensorelektronik, z.B. ein Hallsensor, maximal nahe an einem zu sensierenden Element des Getriebes angeordnet sein kann, d.h. ein möglicher Luftspalt zwischen der Außenfläche 42 des Sensorelements 26 und/oder des Sensorkörpers 27 kann größer sein als bei Sensorelementen, welche mit einer Kunststoffschicht bedeckt sind. Eine derartige Ausgestaltung kann beispielsweise dann sinnvoll sein, wenn die Vergussmasse 38 an dem Sensorelement 26 und/oder dem Sensorkörper 27 bzw. an einem Gehäuse des Sensorelements 26 haften kann, so dass kein Getriebefluid zwischen die Vergussmasse 38 und das Sensorelement 26 gelangen kann. Haftet die Vergussmasse 38 dagegen nicht an dem Sensorelement 26 bzw. dessen Gehäuse, so kann die Außenfläche 42 des Sensorelements 26 auch mit einer dünnen Schicht aus Vergussmasse 38 bedeckt werden, z.B. mit einer Schichtdicke von 0,2 mm.

Zur Positionierung des Sensorelements 26 auf dem Domkörper 20 bzw. auf der Auflagefläche 36 des Domkörpers 20 weist der Sensordom 18 ein Paar von im Wesentlichen parallel zueinander verlaufenden Führungsstegen 46 auf, entlang welcher das Sensorelement 26 während einer Fertigung des Sensordoms 18 verschoben und/oder verlagert werden kann. Zur Positionierung in einer weiteren Raumrichtung kann der Sensordom 18 ferner ein weiteres Paar von im Wesentlichen parallel zueinander verlaufenden Führungsstegen 47 aufweisen, so dass das Sensorelement 26 in zwei zueinander orthogonalen Raumrichtungen auf der Auflagefläche 36 positioniert werden kann. Zumindest ein Teilbereich des Sensorelements 26 kann dabei zur Positionierung desselben an wenigstens einem Teilbereich eines der Führungsstege 46, 47 anliegen. Die Führungsstege 47 und/oder die Führungsstege 46 können zumindest in einem Teilbereich beispielsweise als Vertiefungen oder als Abragungen der Auflagefläche 36 ausgestaltet sein.

Weiter weist der Sensordom 18 und/oder der Domkörper 20 wenigstens einen in Längserstreckungsrichtung des Domkörpers 20 durch die Auflagefläche 36 durchgehende Ausnehmung 49 auf, wobei die Ausnehmung 49 etwa einen Durchbruch bezeichnen kann. Beispielsweise weist der Domkörper 20 zwei Ausnehmungen 49 auf, wobei zumindest ein Teil der Führungsstege 46, 47 jeweils durch einen Teilbereich der Ausnehmungen 49 gebildet sein kann, beispielsweise durch einen Rand und/oder eine Kante der Ausnehmungen 49. Die Ausnehmungen 49 können etwa als durch die Auflagefläche 36 durchgehende Durchbrüche ausgestaltet sein, welche zumindest teilweise mit Vergussmasse 38 befüllt und/oder ausgespritzt sein können. Vorzugsweise sind die Ausnehmungen 49 vollständig mit Vergussmasse 38 befüllt. Derart kann zumindest ein Teilbereich eines Innenvolumens des Domkörpers 20 mit Vergussmasse 38 ausgespritzt werden und die Vergussmasse 38 kann formschlüssig an dem Domkörper 20 befestigt sein, beispielsweise an wenigstens einem durch den Domkörper 20 und/oder die Ausnehmungen 49 ausgebildeten Hinterschnitt 48. Dadurch kann die Vergussmasse 38 sowie das darin zumindest teilweise aufgenommene Sensorelement 26 zuverlässig an dem Domkörper befestigt sein. Je nach Material der Vergussmasse 38 und des Domkörpers 20 kann die Vergussmasse 38 auch eine stoffschlüssige Verbindung mit dem Domkörper 20 eingehen.

Zur Herstellung des in Fig. 2A und 2B gezeigten Sensordomes 18 kann das Sensorelement 26 zusammen mit der an den Kontaktstellen 32 verbundenen Leiterfolie 28 auf die Auflagefläche 36 aufgelegt werden, und über ein Werkzeug, welches auf die Außenfläche 42 des Sensorelements 26 aufgesetzt werden kann, kann das Sensorelement 26 in Richtung der Auflagefläche 36 niedergehalten werden. Über das erste Ende 22 des Domkörpers 20 kann ein Werkzeugstempel in das Innenvolumen des Domkörpers gefahren werden, so dass eine Kavität entstehen kann, welche mit Vergussmasse 38 befüllt, ausgespritzt und/oder gemoldet werden kann. Alternativ kann der Domkörper 20 mit Sensorelement 26 auch kopfüber in einer Vorrichtung positioniert werden und die Vergussmasse 38 kann in das Innenvolumen des Domkörpers 20 gefüllt werden, so dass die Vergussmasse 38 im Erdschwerefeld gehalten ist.

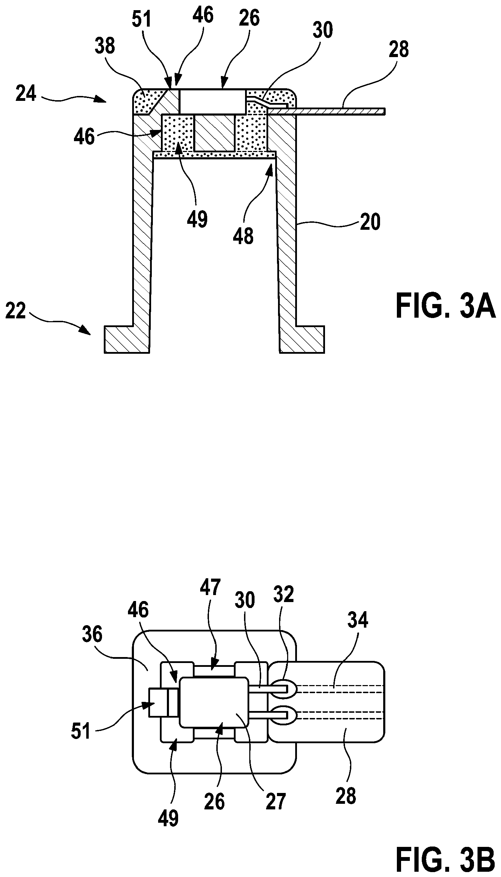

Fig. 3A zeigt einen Längsschnitt durch einen Sensordom 18 für ein Elektronikmodul 10 gemäß einer Ausführungsform der Erfindung. Fig. 3B zeigt eine Draufsicht auf den Sensordom 18 der Fig. 3A. Sofern nicht anders beschrieben, können die Sensordome 18 der Figuren 3A und 3B dieselben Elemente und Merkmale aufweisen wie die in vorangehenden Figuren beschriebenen Sensordome 18.

Bei den in den Figuren 3A und 3B gezeigten Ausführungsbeispielen ist im Bereich eines der Führungsstege 46 ein Anschlagelement 51 ausgebildet, welches in Längserstreckungsrichtung des Domkörpers 20 von der Auflagefläche 36 abragt. Zur Positionierung des Sensorelements 26 auf der Auflagefläche 36 kann zumindest ein Teilbereich, beispielsweise eine Flanke, des Sensorelements 26 an dem Anschlagelement 51 anliegen. Das Anschlagelement 51 kann dabei zumindest teilweise, vorzugsweise vollständig, mit Vergussmasse 38 umspritzt sein. Eine Oberfläche des Anschlagelements 51 kann aus der Vergussmasse 38 herausragen oder mit Vergussmasse 38 bedeckt sein. Es können auch mehrere derartige Anschlagelemente 51 an dem Sensordom 18 ausgebildet sein.

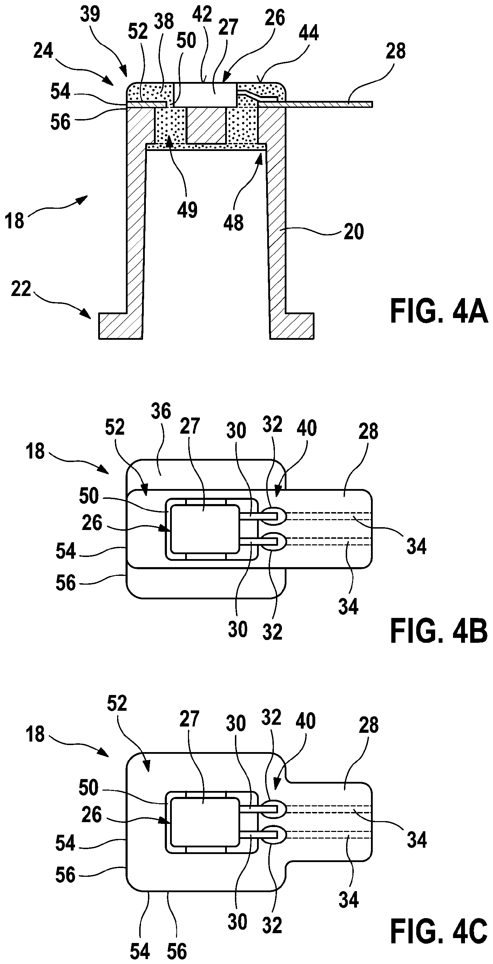

Fig. 4A zeigt einen Längsschnitt durch einen Sensordom18 für ein Elektronikmodul 10 gemäß einer Ausführungsform der Erfindung. Fig. 4B und 4C zeigen jeweils eine Draufsicht auf den Sensordom der Fig. 4A gemäß Ausführungsformen der Erfindung, wobei die Vergussmasse 38in den Fig. 4B und 4C der Übersichtlichkeit halber nicht gezeigt ist. Sofern nicht anders beschrieben, können die Sensordome 18 der Figuren 4A bis 4C dieselben Elemente und Merkmale aufweisen wie die in vorangehenden Figuren beschriebenen Sensordome 18.

Bei den in den Fig. 4A bis 4C gezeigten Ausführungsformen weist die Leiterfolie 28 eine Sensorausnehmung 50 auf, in welcher der Sensorkörper 27 des Sensorelements 26 derart angeordnet ist, dass ein Teilbereich 52 der Leiterfolie 28 den Sensorkörper 27 an einem Außenumfang des Sensorkörpers 27 umläuft und/oder umschließt. Die Sensorausnehmung 50 kann etwa eine in die Leiterfolie 28 eingebrachte Ausstanzung sein und/oder die Sensorausnehmung 50 kann zumindest teilweise, vorzugsweise vollständig, mit Vergussmasse 38 gefüllt sein. Zur Positionierung des Sensorelements 26 auf dem Domkörper 20 und/oder auf der Auflagefläche 36 des Domkörpers 20 kann wenigstens ein Rand bzw. eine Außenkante 54 der Leiterfolie 28 mit einer Außenkante 56 der Auflagefläche 36 und/oder des Domkörpers 20 bündig abschließen.

Auch kann, wie in Fig. 4C gezeigt, der den Sensorkörper 27 umlaufende Teilbereich 52 der Leiterfolie 28 im Wesentlichen ein Form bzw. Kontur der Auflagefläche 36 aufweisen, so dass mehrere Ränder bzw. Außenkanten 54, beispielsweise zwei oder drei Außenkanten 54, der Leiterfolie 28 bündig mit jeweils einer Außenkante 56 der Auflagefläche 36 und/oder des Domkörpers 20 abschließen können. Derart kann das Sensorelement 26 mit hoher Präzision in zwei zueinander orthogonalen Raumrichtungen auf der Auflagefläche 36 des Domkörpers 20 positioniert werden und anschließend mit Vergussmasse 38 fixiert und/oder geschützt werden.

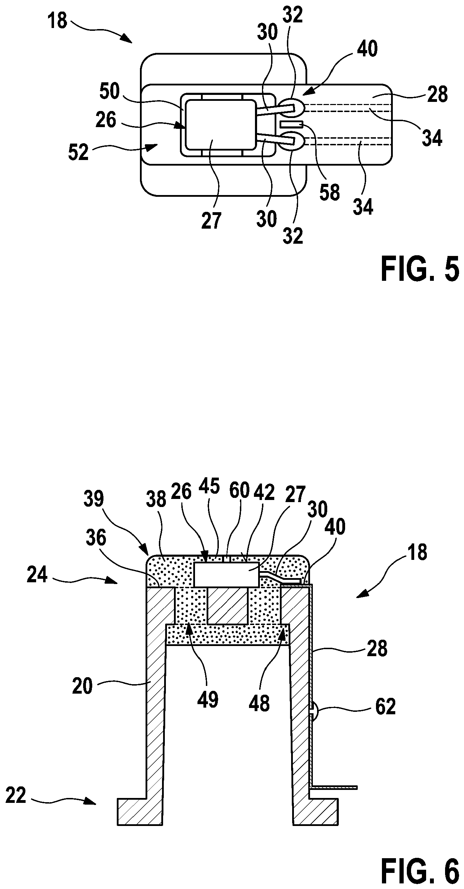

Fig. 5 zeigt eine Draufsicht auf einen Sensordom 18 für ein Elektronikmodul 10 gemäß einer Ausführungsform der Erfindung, wobei die Vergussmasse 38 in der Fig. 5 der Übersichtlichkeit halber nicht gezeigt ist. Sofern nicht anders beschrieben, kann der Sensordom 18 der Figur 5 dieselben Elemente und Merkmale aufweisen wie die in vorangehenden Figuren beschriebenen Sensordome 18.

Bei dem in Fig. 5 gezeigten Ausführungsbeispiel weist die Leiterfolie 28 eine zwischen den Kontaktstellen 32 und/oder zwischen den Leiterbahnen 34 der Leiterfolie 28 angeordnete Ausnehmung 58 auf, welche etwa als eine in die Leiterfolie 28 eingebrachte Ausstanzung ausgebildet sein kann.

Die Ausnehmung 58 ist in Fig. 5 getrennt von der Sensorausnehmung 50 gezeigt. Alternativ kann die Ausnehmung 58 auch zusammen mit der Sensorausnehmung 50 eine durchgehende Ausnehmung bilden.

Die zwischen den Kontaktstellen 32 angeordnete Ausnehmung 58 ist zumindest teilweise mit Vergussmasse 38 gefüllt und/oder ausgespritzt. Vorzugsweise ist die Ausnehmung 58 vollständig mit Vergussmasse 38 befüllt und/oder ausgespritzt. Zum einen kann dadurch die Leiterfolie 28 in der Vergussmasse 38 verankert und/oder fixiert sein und zum anderen kann die in der Ausnehmung 58 angeordnete Vergussmasse 38 eine Barriere zwischen den Leitungen 30 und/oder den Kontaktstellen und/oder den Leiterbahnen 34 bereitstellen, durch welche Kurz- und/oder Nebenschlüsse vermieden werden können. Mit anderen Worten können die Leitungen 30, die Kontaktstellen 32 und/oder die Leiterbahnen 34 durch die Vergussmasse 38 getrennt sein, so dass keine elektrische Verbindung durch leitfähige Ablagerungen (Cu-Korrosion), Späne, Elektronenmigration und/oder Ähnliches über die Oberfläche der Leiterfolie 28 entstehen kann.

Fig. 6 zeigt einen Längsschnitt durch einen Sensordom 18 für ein Elektronikmodul 10 gemäß einer Ausführungsform der Erfindung. Sofern nicht anders beschrieben, kann der Sensordom 18 der Figur 6 dieselben Elemente und Merkmale aufweisen wie die in vorangehenden Figuren beschriebenen Sensordome 18.

Bei dem in Fig. 6 gezeigten Ausführungsbeispiel ist die Außenfläche 42 des Sensorkörpers 27 und/oder des Sensorelements 26 mit einer Schicht 45 aus Vergussmasse 38 bedeckt. Die Schicht 45 weist dabei ein Dicke von weniger als 2 mm, beispielsweise weniger als 1 mm, auf. Vorzugsweise weist die Schicht 45 eine Dicke von rund 0,3mm bis 0,6 mm auf.

Herstellungsbedingt kann in der Schicht 45 eine Aussparung 60 angeordnet sein, welche etwa dadurch entstehen kann, dass der Sensorkörper 27 während der Fertigung mit einem Stempel auf der Auflagefläche 36 gehalten sein kann, um ein Aufschwimmen des Sensorkörpers 27 in der Vergussmasse 38 zu verhindern.

Ferner ist die Leiterfolie 28 seitlich des Domkörpers 20 heruntergeklappt und liegt zumindest in einem Teilbereich an einer Flanke des Domkörpers 20 an. Die Leiterfolie 28 kann an der Flanke des Domkörpers 20 mit einer Fixiervorrichtung 62 befestigt sein, z. B. durch Auffädeln auf einen Zapfen am Sensordom 18 bzw. dem Domkörper 20, der zusätzlich warm genietet werden kann.

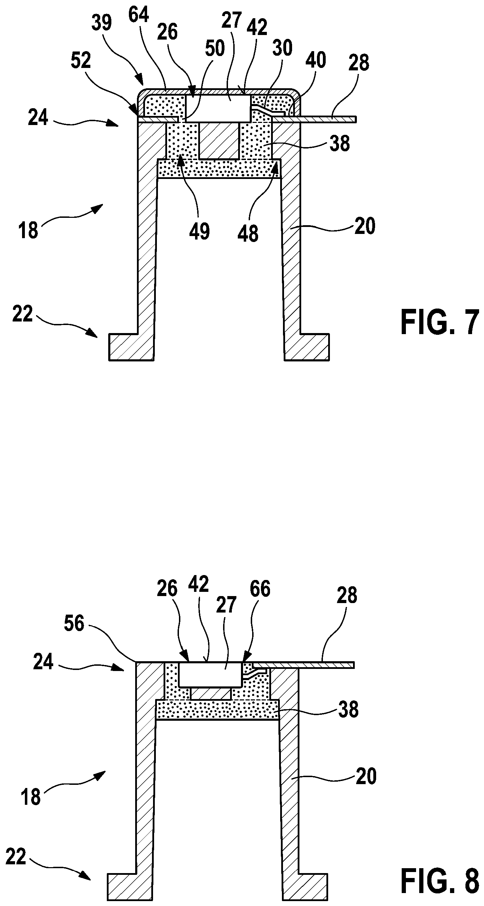

Fig. 7 zeigt einen Längsschnitt durch einen Sensordom 18 für ein Elektronikmodul 10 gemäß einer Ausführungsform der Erfindung. Sofern nicht anders beschrieben, kann der Sensordom 18 der Figur 7 dieselben Elemente und Merkmale aufweisen wie die in vorangehenden Figuren beschriebenen Sensordome 18.

Der Sensordom 18 der Fig. 7 weist eine Abschlusskappe 64 auf, welche die Außenfläche 42 des Sensorelements 26 zumindest teilweise überdeckt. Die Abschlusskappe 64 kann ein Kunststoffformteil sein. Zur Herstellung des Sensordoms 18 kann die Abschlusskappe 64 etwa in eine Form eines Werkzeugs eingelegt werden oder auf das Sensorelement 26 aufgelegt werden und der Sensordom 18 kann mit Abschlusskappe 64 kopfüber positioniert werden, so dass über das erste Ende 22 des Sensordoms 18 die Vergussmasse 38 in das Innenvolumen des Domkörpers 29 eingebracht werden kann. Um ein Anhaften der Vergussmasse 38 an dem Werkzeug zu verhindern und das Sensorelement 26 ferner zu schützen, kann die Abschlusskappe 64 am Sensordom 18 verbleiben.

Fig. 8 zeigt einen Längsschnitt durch einen Sensordom 18 für ein Elektronikmodul 10 gemäß einer Ausführungsform der Erfindung. Sofern nicht anders beschrieben, kann der Sensordom 18 der Figur 8 dieselben Elemente und Merkmale aufweisen wie die in vorangehenden Figuren beschriebenen Sensordome 18.

Bei dem in Fig. 8 gezeigten Ausführungsbeispiel schließt die Außenfläche 42 bündig mit der Auflagefläche 36 des Domkörpers 20 ab. Dazu ist der Sensorkörper 27 in einer Vertiefung 66 des Domkörpers 20 aufgenommen, welche zumindest teilweise, vorzugsweise vollständig, mit Vergussmasse 38 befüllt und/oder ausgespritzt ist.

Zur Herstellung des Sensordoms 18 kann das Sensorelement 26 und/oder der Sensorkörper 27 in die Vertiefung 66 eingelegt werden und ein Werkzeugstempel kann über das Ende 22 in das Innenvolumen des Domkörpers 20 gefahren werden. Von dem Ende 24 her kann dann die Vergussmasse 38 eingespritzt und/oder das Sensorelement 26 vergossen bzw. gemoldet werden. Die Leiterfolie 28 kann in Dicke und Breite mit sehr kleinen Maßschwankungen hergestellt werden, weshalb die Leiterfolie 28 seitlich herausgeführt werden kann und zwischen Domkörper 20 und Werkzeug eingeklemmt werden kann, während die Vergussmasse 38 eingebracht wird.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Bezugszeichen in den Ansprüchen sind nicht als Einschränkung anzusehen.

## Patentansprüche

1. Elektronikmodul (10) für ein Getriebesteuergerät eines Kraftfahrzeugs, aufweisend:
eine Getriebesteuereinheit (12) mit einer elektronischen Schaltung (14);
wenigstens ein Trägerelement (16), auf dem die elektronische Schaltung (14) angeordnet und befestigt ist; und
wenigstens einen Sensordom (18),
wobei der Sensordom einen länglich ausgebildeten Domkörper (20) aufweist, welcher mit einem ersten Ende (22) auf einem Trägerelement (16), angeordnet ist und welcher von diesem abragt,
wobei der Sensordom an einem dem ersten Ende gegenüberliegenden zweiten Ende (24) ein elektronisches Sensorelement (26) aufweist,
welches wenigstens zwei elektrische Leitungen (30) aufweist, welche jeweils an einer Kontaktstelle (32) mit einer zwischen einer Deckschicht und einer Basisschicht angeordneten Leiterbahn (34) einer Leiterfolie (28) elektrisch leitfähig verbunden sind,
wobei die Leiterbahnen der Leiterfolie jeweils mit der elektronischen Schaltung der Getriebesteuereinheit elektrisch leitfähig verbunden sind, und
wobei das Sensorelement mit einer Vergussmasse (38) umspritzt ist, welche das Sensorelement zumindest an einem Außenumfang des Sensorelements vollständig umschließt,
wobei die wenigstens zwei elektrischen Leitungen des Sensorelements, die Kontaktstellen und ein Bereich (40) der Leiterfolie von der Vergussmasse derart umspritzt sind, dass die elektrischen Leitungen und die Kontaktstellen durch die Vergussmasse voneinander getrennt sind.

2. Elektronikmodul (10) nach Anspruch 1, wobei die Leiterfolie eine Sensorausnehmung (50) aufweist und das Sensorelement einen Sensorkörper (27) aufweist, welcher in der Sensorausnehmung der Leiterfolie angeordnet ist, so dass ein Teilbereich (52) der Leiterfolie den Sensorkörper an einem Außenumfang umläuft.

3. Elektronikmodul (10) nach Anspruch 2, wobei eine an dem Teilbereich (52) der Leiterfolie angeordnete Außenkante (54) der Leiterfolie zur Positionierung des Sensorelements auf dem Domkörper bündig mit einer Außenkante (56) des Domkörpers abschließt.

4. Elektronikmodul (10) nach einem der Ansprüche 2 oder 3, wobei die Sensorausnehmung (50) zusammen mit einer zwischen den Kontaktstellen (32) angeordneten Ausnehmung (58) der Leiterfolie eine durchgehende Ausnehmung der Leiterfolie bildet, welche zumindest teilweise mit Vergussmasse ausgespritzt ist.

5. Elektronikmodul (10) nach einem der voranstehenden Ansprüche, wobei die Leiterfolie zwischen den Kontaktstellen (32) eine Ausnehmung (58) aufweist,
wobei die Ausnehmung (58) zwischen den Kontaktstellen zumindest teilweise mit der Vergussmasse (38) gefüllt ist.

6. Elektronikmodul (10) nach einem der voranstehenden Ansprüche, wobei die Vergussmasse formschlüssig an wenigstens einem durch den Domkörper ausgebildeten Hinterschnitt (48) an dem zweiten Ende (24) des Domkörpers gehalten ist.

7. Elektronikmodul (10) einem der voranstehenden Ansprüche, wobei die Vergussmasse (38) ein Material enthält aus der Gruppe bestehend aus duroplastischem Material, thermoplastischem Material, epoxidharzbasiertem Material, silikonbasiertem Material, Polyurethan, Acrylklebstoff.

8. Elektronikmodul (10) nach einem der voranstehenden Ansprüche, wobei eine Außenfläche (42) des Sensorelements (26) bündig mit einer Außenfläche (44) der Vergussmasse (38) abschließt.

9. Elektronikmodul (10) nach einem der voranstehenden Ansprüche, wobei eine Außenfläche (42) des Sensorelements mit einer Schicht (45) aus Vergussmasse bedeckt ist, welche eine Schichtdicke von maximal 2 mm aufweist; und/oder
wobei der Sensordom (18) eine Abschlusskappe (54) aufweist, welche die Außenfläche (42) des Sensorelements zumindest teilweise überdeckt.

10. Elektronikmodul (10) nach einem der voranstehenden Anspruche, wobei der Domkörper (20) an dem zweiten Ende (24) wenigstens einen Führungssteg (46) zur Positionierung des Sensorelements (26) auf dem Domkörper (20) aufweist.

## Claims

1. Electronics module (10) for a transmission controller of a motor vehicle, having:
a transmission control unit (12) having an electronic circuit (14);
at least one carrier element (16) on which the electronic circuit (14) is arranged and fastened; and
at least one sensor dome (18),
wherein the sensor dome has a dome body (20) of elongate design that is arranged with a first end (22) on a carrier element (16) and that protrudes therefrom,
wherein the sensor dome has an electronic sensor element (26) on a second end (24) opposite the first end, which electronic sensor element has at least two electrical lines (30) that are each electrically conductively connected, at a contact point (32), to a conductor track (34), arranged between a cover layer and a base layer, of a conductor foil (28),
wherein the conductor tracks of the conductor foil are each electrically conductively connected to the electronic circuit of the transmission control unit, and wherein the sensor element is encapsulated with a casting compound (38) that completely encloses the sensor element at least on an outer circumference of the sensor element,
wherein the at least two electrical lines of the sensor element, the contact points and a region (40) of the conductor foil are encapsulated by the casting compound such that the electrical lines and the contact points are isolated from one another by the casting compound.

2. Electronics module (10) according to Claim 1, wherein the conductor foil has a sensor recess (50) and the sensor element has a sensor body (27) that is arranged in the sensor recess in the conductor foil such that a subregion (52) of the conductor foil runs around an outer circumference of the sensor body.

3. Electronics module (10) according to Claim 2, wherein an outer edge (54) of the conductor foil, arranged on the subregion (52) of the conductor foil, terminates flush with an outer edge (56) of the dome body in order to position the sensor element on the dome body.

4. Electronics module (10) according to either of Claims 2 and 3, wherein the sensor recess (50), together with a recess (58), arranged between the contact points (32), in the conductor foil forms a continuous recess in the conductor foil that is injected at least partially with casting compound.

5. Electronics module (10) according to one of the preceding claims, wherein the conductor foil has a recess (58) between the contact points (32),
wherein the recess (58) between the contact points is filled at least partially with the casting compound (38).

6. Electronics module (10) according to one of the preceding claims, wherein the casting compound is held in a form-fitting manner on at least one rear section (48), formed by the dome body, on the second end (24) of the dome body.

7. Electronics module (10) according to one of the preceding claims, wherein the casting compound (38) contains a material from the group consisting of duroplastic material, thermoplastic material, epoxy resin-based material, silicone-based material, polyurethane and acrylic adhesive.

8. Electronics module (10) according to one of the preceding claims, wherein an outer surface (42) of the sensor element (26) terminates flush with an outer surface (44) of the casting compound (38).

9. Electronics module (10) according to one of the preceding claims, wherein an outer surface (42) of the sensor element is covered with a layer (45) of casting compound that has a layer thickness of at most 2 mm; and/or
wherein the sensor dome (18) has an end cap (54) that at least partially covers the outer surface (42) of the sensor element.

10. Electronics module (10) according to one of the preceding claims, wherein the dome body (20), at the second end (24), has at least one guide bar (46) for positioning the sensor element (26) on the dome body (20) .

## Revendications

1. Module électronique (10) pour un appareil de commande de transmission d'un véhicule automobile, présentant :
une unité de commande de transmission (12) dotée d'un circuit électronique (14) ;
au moins un élément de support (16) sur lequel est disposé et fixé le circuit électronique (14) ; et
au moins un dôme de capteur (18),
le dôme de capteur présentant un corps de dôme (20) réalisé de manière allongée, qui est disposé par une première extrémité (22) sur un élément de support (16) et qui fait saillie de celui-ci,
le dôme de capteur présentant à une deuxième extrémité (24) opposée à la première extrémité un élément de capteur électronique (26) qui présente au moins deux lignes électriques (30) qui sont reliées de manière électriquement conductrice respectivement en un point de contact (32) à une piste conductrice (34) d'une feuille conductrice (28) disposée entre une couche de recouvrement et une couche de base,
dans lequel les pistes conductrices de la feuille conductrice sont respectivement reliées de manière électriquement conductrice au circuit électronique de l'unité de commande de transmission, et
dans lequel l'élément de capteur est enrobé d'une masse de scellement (38) qui entoure l'élément de capteur complètement, au moins sur une circonférence extérieure de l'élément de capteur,
dans lequel les au moins deux lignes électriques de l'élément de capteur, les points de contact et une zone (40) de la feuille conductrice sont enrobés de la masse de scellement de telle sorte que les lignes électriques et les points de contact sont séparés les uns des autres par la masse de scellement.

2. Module électronique (10) selon la revendication 1, dans lequel la feuille conductrice présente un évidement de capteur (50) et l'élément de capteur présente un corps de capteur (27) qui est disposé dans l'évidement de capteur de la feuille conductrice de sorte qu'une partie (52) de la feuille conductrice contourne le corps de capteur sur la circonférence extérieure.

3. Module électronique (10) selon la revendication 2, dans lequel un bord extérieur (54) de la feuille conductrice, disposé sur la partie (52) de la feuille conductrice, est aligné à fleur sur un bord extérieur (56) du corps de dôme pour positionner l'élément de capteur sur le corps de dôme.

4. Module électronique (10) selon l'une quelconque des revendications 2 ou 3, dans lequel l'évidement de capteur (50) constitue avec un évidement (58) de la feuille conductrice, disposé entre les points de contact (32), un évidement continu de la feuille conductrice qui est rempli au moins en partie avec une masse de scellement.

5. Module électronique (10) selon l'une quelconque des revendications précédentes, dans lequel la feuille conductrice présente un évidement (58) entre les points de contact (32),
l'évidement (58) étant au moins en partie rempli avec la masse de scellement (38) entre les points de contact.

6. Module électronique (10) selon l'une quelconque des revendications précédentes, dans lequel la masse de scellement est maintenue par complémentarité de forme au niveau d'au moins une contre-dépouille (48) réalisée par le corps de dôme à la deuxième extrémité (24) du corps de dôme.

7. Module électronique (10) selon l'une quelconque des revendications précédentes, dans lequel la masse de scellement (38) contient un matériau issu du groupe composé d'un matériau thermodurcissable, d'un matériau thermoplastique, d'un matériau à base de résine époxy, d'un matériau à base de silicone, de polyuréthane, d'un adhésif acrylique.

8. Module électronique (10) selon l'une quelconque des revendications précédentes, dans lequel une surface extérieure (42) de l'élément de capteur (26) est alignée à fleur avec une surface extérieure (44) de la masse de scellement (38).

9. Module électronique (10) selon l'une quelconque des revendications précédentes, dans lequel une surface extérieure (42) de l'élément de capteur est recouverte d'une couche (45) composée d'une masse de scellement qui présente une épaisseur de couche d'un maximum de 2 mm ; et/ou
dans lequel le dôme de capteur (18) présente un capuchon (54) qui recouvre la surface extérieure (42) de l'élément de capteur au moins en partie.

10. Module électronique (10) selon l'une quelconque des revendications précédentes, dans lequel le corps de dôme (20) présente à la deuxième extrémité (24) au moins une nervure de guidage (46) pour positionner l'élément de capteur (26) sur le corps de dôme (20).
